# EUROPÄISCHE PATENTSCHRIFT

(11) **EP 0 253 344 B1**
(45) Veröffentlichungstag und Bekanntmachung des Hinweises auf die Patenterteilung: **09.06.1993**
(21) Anmeldenummer: 87110062.4
(22) Anmeldetag: 11.07.1987
(51) Int. Cl.: H01J 37/34

(54) **Zerstäubungskatode nach dem Magnetronprinzip**
Sputtering cathode based on the magnetron principle
Cathode de pulvérisation selon le principe magnétron

(30) Priorität: 17.07.1986 DE 3624150
(43) Veröffentlichungstag der Anmeldung: 20.01.1988
(73) Patentinhaber: LEYBOLD AKTIENGESELLSCHAFT, D-63450 Hanau (DE)
(72) Erfinder: Wirz, Peter, Dr., D-6296 Waldernbach (DE); Przybilla, Gudrun, Dipl.-Ing., D-8755 Alzenau (DE); Schuller, Karl-Heinz, D-6053 Obertshausen (DE); Cord, Bernd, Dr., D-8755 Alzenau-Albstadt (DE)
(74) Vertreter: Zapfe, Hans, Dipl.-Ing.

(56) Entgegenhaltungen:
- EP-A- 0 162 642
- US-A- 4 426 264
- PATENT ABSTRACTS OF JAPAN, Band 7, Nr. 175 (C-179)[1320], 3. August 1983 & JP-A-58 81 969

## Beschreibung

Die Erfindung betrifft eine Zerstäubungskatode nach dem Magnetronprinzip mit einem aus mindestens einem Teil bestehenden Target aus dem zu zerstäubenden Material, mit einem hinter dem Target angeordneten, im wesentlichen in einer Ebene ausgebreiteten Magnetsystem mit mehreren, ineinanderliegenden und in sich geschlossenen Magneteinheiten abwechselnd unterschiedlicher Polung, durch die mindestens zwei gleichfalls in sich geschlossene, ineinanderliegende magnetische Tunnels aus bogenförmig gekrümmten Feldlinien gebildet werden, wobei die dem Target abgekehrten Pole der Magneteinheiten über ein Magnetjoch aus weichmagnetischem Material miteinander verbunden sind.

Durch die DE-A-34 42 206 ist eine Zerstäubungskatode der eingangs beschriebenen Gattung bekannt, die für die Zerstäubung von Targets aus ferromagnetischen Werkstoffen vorgesehen ist. Bei einem der beiden Ausführungsbeispiele werden durch zwei konzentrisch ineinanderliegende Magneteinheiten in Verbindung mit zwei konzentrischen, in dem Target angeordneten Luftspalten zwei in sich geschlossene, ineinanderliegende magnetische Tunnels aus bogenförmig gekrümmten Feldlinien gebildet. Da aber hierbei die magnetischen Felder über die beiden Luftspalte magnetisch in Reihe geschaltet sind, lassen sich die Feldstärken der beiden Tunnels nicht unabhängig voneinander beeinflussen. Dadurch entstehen im Bereich der beiden magnetischen Tunnels voneinander verschiedene Zerstäubungsraten und im Bereich des dem Target gegenüberliegenden Substrats auch sehr unterschiedliche Niederschlagsraten, so daß die Schichtdickenverteilung sehr ungleichförmig ist.

Durch die DE-A-22 43 708 ist es bekannt, bei Stabkatoden Magneteinheiten in axialer Richtung hintereinander anzuordnen, um dadurch die Zerstäubung des Targetmaterials zu vergleichmäßigen. Auch für die dort beschriebenen planaren Targets wird angegeben, daß man konzentrische, ineinanderliegende Magneteinheiten und mehrere konzentrisch ineinanderliegende magnetische Tunnels vorsehen kann. Auch hier sind Möglichkeiten einer getrennten Einstellung eines jeden magnetischen Tunnels unabhängig vom jeweils benachbarten Tunnel nicht vorgesehen und auch nicht möglich.

Durch eine unter der Bezeichnung "Con Mag" von der Firma Varian vertriebene Zerstäubungskatode der eingangs beschriebenen Gattung ist es weiterhin bekannt, innerhalb einer kreisringförmigen Jochplatte mit Abstand eine kreisscheibenförmige Jochplatte vorzusehen und jeder Jochplatte zwei unabhängig voneinander wirkende entgegengesetzt gepolte Magneteinheiten zuzuordnen, wobei über dem kreisringförmigen Magnetsystem ein Target mit einer kegelförmigen Zerstäubungsfläche und über dem kreisscheibenförmigen Magnetsystem eine ebene Targetplatte angeordnet ist. Mittel für die Beeinflussung der Magnetfeldstärke der zwei gebildeten Tunnels unabhängig voneinander, sind nicht vorgesehen. Auch bei dieser Zerstäubungskatode muß der Zerstäubungseffekt so in Kauf genommen werden, wie er durch die relative Läge der magnetischen Tunnels zu den Zerstäubungsflächen vorgegeben ist.

Nun hat der Abstand des Magnetsystems bzw. der Magnetsysteme von dem Target, insbesondere dann, wenn es aus einem nicht-ferromagnetischen Werkstoff besteht, einen erheblichen Einfluß auf die Feldlinienverteilung über der Zerstäubungsfläche und damit auf das sogenannte "Erosionsprofil". Um den zunehmenden Verbrauch des Targetmaterials durch Ausbildung eines Erosionsgrabens zu kompensieren, wird in der DE-A-30 47 113 angegeben, mit fortschreitendem Verbrauch des Targetmaterials den Abstand des Magnetsystems von der Targetrückseite zu verändern. Das betreffende Magnetsystem besteht jedoch nur aus zwei Magneteinheiten, die einen einzigen magnetischen Tunnel erzeugen, so daß dieser Druckschrift gleichfalls keine Anregungen für die Beeinflussung der Schichtdickenverteilung bei der Anwendung von zwei oder mehr konzentrisch ineinanderliegenden magnetischen Tunnels zu entnehmen sind.

Hinzu kommt, daß beim Einsatz eines einzigen geschlossenen magnetischen Tunnels eine große Abhängigkeit der Schichtdickenverteilung auf den Substraten auch vom Abstand zwischen Substrat und Target gegeben ist. Messungen haben gezeigt, daß bei einem zu großen Abstand zwischen Target und (stationärem) Substrat eine zu große Schichtdicke in der Mitte des Substrats zu beobachten ist, die zu den Rändern hin stark abfällt. Bei einem zu geringen Abstand zwischen Target und (stationärem) Substrat kann beobachtet werden, daß die Schichtdicke im Bereich des Erosionsgrabens besonders groß ist, während sie beiderseits des Erosionsgrabens stark abfällt. Dies führt dazu, daß man mit derartigen Zerstäubungskatoden nur Substrate beschichten kann, die einen sehr viel geringeren Durchmesser als das Target aufweisen.

Die weiter oben beschriebene Zerstäubungskatode "Con Mag" der Firma Varian entspringt dem Versuch, die Schichtdickenverteilung zu verbessern, indem man nicht nur die Magnetsysteme, sondern auch die zugehörigen Targetteile elektrisch völlig entkoppelt hat. Dies setzt jedoch den Einsatz von zwei Stromquellen pro Zerstäubungskatode voraus, weiterhin auch eine elektrische Isolation der Target- bzw. Katodenteile voneinander. Für die Zerstäubung von Targets aus ferromagnetischen Werkstoffen ist ein solches System nicht geeignet.

Durch die DE-A-35 06 227 ist eine Zerstäubungskatode bekannt, die als Hohl- bzw. Topfkatode ausgebildet ist und zwei voneinander völlig unabhängige Magneteinheiten aufweist, die nicht durch ein gemeinsames Joch miteinander verbunden sind. Die bekannte Anordnung ist dafür vorgesehen, bei Substraten mit starker Oberflächenprofilierung eine verbesserte Stufenbedeckung zu erzielen. Um dabei die Zerstäubungsrate im Bereich der einzelnen Erosionsgräben unabhängig voneinander variieren zu können, sind bei einem Ausführungsbeispiel zwei voneinander getrennte Elektromagnete vorgesehen, deren Erregerwicklungen mit unterschiedlichen Strömen beaufschlagt werden können. Bei dieser Anordnung sind die Elektromagnete stationär zueinander angeordnet. Elektromagnete haben einen hohen Leistungsbedarf zur Folge, die zu einer merklichen Spulenerwärmung führt, so daß außer der relativ hohen Wärmebelastung des zu zerstäubenden Targets auch noch die Stromwärme durch ein entsprechend wirksames Kühlsystem abgeführt werden muß. Die Folge ist ein relativ ungünstiger Wirkungsgrad. Bei einem zweiten Ausführungsbeispiel werden Permanentmagnete verwendet, die jedoch keine relative Veränderung der Zerstäubungsraten zulassen. Um hierbei den gleichen Effekt einer Veränderung der relativen Zerstäubungsraten erzielen zu können, ist es erforderlich, die einzelnen Teile eines unterteilten Targets auf unterschiedliches, variables Potential zu legen, um durch die Zerstäubungsspannung eine unterschiedliche Zerstäubungsrate zu erzwingen. Dies bedingt jedoch wiederum für jedes Target- bzw. Katodenteil eine unterschiedliche Leistungsversorgung. Um bei einem solchen System eine gleichmäßige Schichtdicke erzeugen zu können, müssen die Permanentmagnete exzentrisch angeordnet werden, um bei ihrem Umlauf relativ zueinander eine Taumelbewegung auszuführen. Dies hat den Nachteil, daß die Zerstäubungszone auf den einzelnen Targetoberflächen laufend verschoben wird, so daß Oberflächenteile mit unterschiedlicher Beschaffenheit nacheinander zerstäubt werden. Dies führt wiederum zu einem inhomogenen Schichtaufbau.

Ein weiterer Nachteil der bekannten Hohlkatode liegt darin, daß ihr Bauprinzip auf eine rotationssymmetrische Ausbildung beschränkt ist. Es ist mithin nicht möglich, mit einem solchen System streifenförmiges Material (Folien) oder große Platten (Glas) in kontinuierlichem Durchlauf zu beschichten.

Der Erfindung liegt daher die Aufgabe zugrunde, eine Zerstäubungskatode anzugeben, die sowohl für magnetische als auch für nicht-magnetische Targetmaterialien geeignet ist, die Beschichtung großer Flächen bei laufendem Durchgang der Substrate erlaubt, zu einer sehr gleichmäßigen Schichtdickenverteilung führt und dennoch mit nur einer einzigen Stromversorgung zu betreiben ist.

Die Lösung der gestellten Aufgabe erfolgt bei der eingangs beschriebenen Zerstäubungskatode erfindungsgemäß dadurch, daß mindestens drei ineinanderliegende permanentmagnetische Magneteinheiten vorhanden sind, und daß eine mechanische Verstelleinrichtung vorhanden ist, durch die der magnetische Fluß zwischen dem Magnetjoch und mindestens einer Magneteineinheit gegenüber dem magnetischen Fluß zwischen dem Magnetjoch und den übrigen Magneteinheiten veränderbar ist.

Erfindungsgemäß werden mithin die verschiedenen Magneteinheiten des Magnetsystems verstellbar entkoppelt, während das Target oder die Targetteile elektrisch ein einheitliches System bilden, für das auch nur eine einzige Stromversorgung benötigt wird.

Gegenüber der DE-A-35 06 227 ist hierbei von besonderer Bedeutung, daß die Magnetsysteme im wesentlichen in einer Ebene ausgebreitet sind. Bei einem rotationssymmetrischen System bedeutet dies, daß die Magnetsysteme unter Aufrechterhaltung des Flusses zum gleichen Magnetjoch in radialer Richtung aneinander gereiht sind. Die Polflächen und/oder die Begrenzungsflächen des Magnetjochs liegen dabei zumindest im wesentlichen in bzw. zwischen koplanaren Ebenen. Aufgrund dieser Bauweise kann die Zerstäubunoskatode beispielsweise in ihrer Draufsicht auch rechteckig oder in Form einer "Rennbahn" ausgebildet sein.

Dabei benötigt das System keinen ständigen Magnetisierungsstrom. Durch die Einstellung der magnetischen Feldstärke im Bereich des einen Tunnels relativ zu der Feldstärke oder den Feldstärken im Bereich der jeweils anderen, benachbarten Tunnels, wird eine individuelle Anpassung der spezifischen Zerstäubungsleistung erreicht, d.h. das Targetmaterial kann im Bereich der verschiedenen magnetischen Tunnels auch unterschiedlich stark zerstäubt werden, womit die Zerstäubungsrate der geforderten Niederschlagsrate angepaßt werden kann.

Eine solche Zerstäubungskatode ist auch ohne besonderen Aufwand unterschiedlichen Abständen zwischen Target und Substrat anpaßbar.

Die Verstelleinrichtung wird dabei in der Regel zu Beginn des Prozesses ein einziges mal im Hinblick auf optimale Prozeßparameter eingestellt, und die Einstellung wird danach nicht mehr verändert.

Eine derartige Verstelleinrichtung kann gemäß der weiteren Erfindung dadurch gebildet werden, daß das Magnetjoch aus je einem äußeren und einem inneren Jochteil besteht, die unter Veränderung des zwischen ihnen bestehenden magnetischen Übergangswiderstandes relativ zueinander verstellbar sind.

In dem zuletzt genannten Fall besteht das äußere Jochteil beispielsweise aus einem Kreisring und das innere Jochteil aus einer Kreisscheibe, die mehr oder weniger stark in den Kreisring eintauchen kann, wobei eine Verstellung durch eine Gewindespindel herbeiführbar ist. Die Überlappung zwischen dem äußeren und dem inneren Jochteil bestimmt den magnetischen Übergangswiderstand. Auf dem äußeren Jochteil sind dann vorteilhaft starr zueinander zwei ineinanliegende und in sich geschlossene Magneteinheiten angeordnet, die zur Ausbildung eines magnetischen Tunnels über der Zerstäubungsfläche dienen, während auf dem inneren Jochteil eine Magneteinheit angeordnet ist, die mit der auf dem äußeren Jochteil angeordneten inneren Magneteinheit in magnetischer Wechselwirkung steht, so daß an dieser Stelle ein zweiter magnetischer Tunnel ausgebildet wird. Während der äußere magnetische Tunnel durch die starre Anordnung der Magneteinheiten relativ zueinander im wesentlichen nicht beeinflußbar ist, läßt sich die Stärke des Magnetfeldes des inneren magnetischen Tunnels durch Veränderung des magnetischen Übergangswiderstandes im Bereich des Jochs zwischen den beiden inneren Magneteinheiten in weiten Grenzen beinflussen. Dadurch läßt sich die gewünschte Abstimmung im Hinblick auf die gewünschte Schichtdickenverteilung herbeiführen.

Es ist dabei wiederum besonders vorteilhaft, wenn mit der Veränderung des magnetischen Übergangswiderstandes auch der Abstand mindestens eines der Jochteile vom Target veränderbar ist. Auf diese Weise ist eine sehr gezielte Einstellung der örtlichen Zerstäubungsrate einerseits und der Niederschlagsrate andererseits möglich.

Eine andere alternative Ausführungsform des Erfindungsgegenstandes ist dadurch gekennzeichnet, daß das Magnetjoch auf einem Teil seiner Oberfläche einen Vorsprung aufweist, auf dem eine der Magneteinheiten im wesentlichen kongruent mit dem Vorsprung angeordnet ist, und wenn auf dem Vorsprung eine aus weichmagnetischem Material bestehende, am Vorsprung eng anliegende und auf diesem verschiebbare Hülse angeordnet ist, die in axialer Richtung über die Magneteinheit derart verstellbar ist, daß ein Maß "s" der Überlappung von Hülse und Magneteinheit veränderbar ist.

Auf die zuletzt beschriebene Weise wird eine Art magnetischer "Shunt" gebildet, der bei einer großen Überlappung zwischen Hülse und Magneteinheit einen beträchtlichen Teil des magnetischen Feldes auf sich vereinigt und auf dem kürzesten Wege in die Jochplatte leitet, wobei dieser Teil des magnetischen Flusses demjenigen magnetischen Fluß entzogen wird, der über dem Target den gewünschten magnetischen Tunnel aufbaut.

Weitere vorteilhafte Ausgestaltungen des Erfindungsgegenstandes ergeben sich aus den übrigen Unteransprüchen.

Ausführungsbeispiele des Erfindungsgegenstandes werden nachfolgend anhand der Figuren 1 bis 6 näher erläutert.

Es zeigen:
- Figur 1: einen Axialschnitt durch eine Zerstäubungskatode mit einem dreiteiligen Target aus ferromagnetischem Material, das zwei Luftspalte zwischen sich einschließt,
- Figur 2: einen Axialschnitt analog Figur 1 jedoch mit einem Target aus einem nicht-ferromagnetischen Material,
- Figuren 3/4: eine Verstelleinrichtung für die Verstellung des magnetischen Flusses innerhalb des Magnetjochs gemäß den Figuren 1 und 2, Figuren 5/6 eine Verstelleinrichtung mit einem magnetischen Shunt als alternative Lösung.

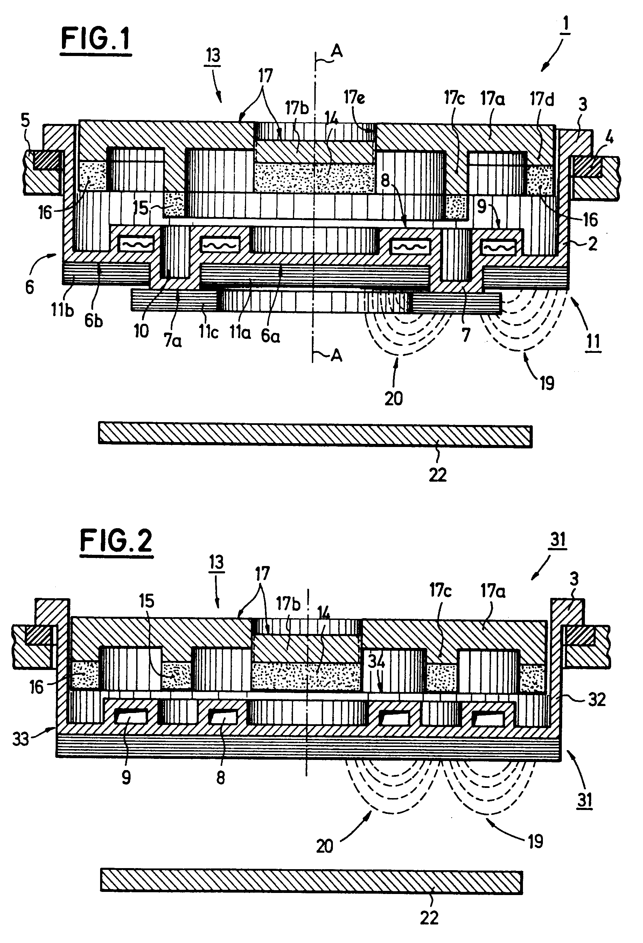

In Figur 1 ist eine Zerstäubungskatode 1 dargestellt, deren tragender Teil ein topfförmiger, hohler Grundkörper 2 ist, der wegen der thermischen Belastung aus einem gut wärmeleitenden Werkstoff (Kupfer) besteht und mittels eines umlaufenden Flansches 3 unter Zwischenschaltung eines Isolierstoffkörpers 4 in eine Wand 5 einer hier nicht näher gezeigten Vakuumkammer eingesetzt ist.

Der Grundkörper 2 besitzt eine größtenteils ebene Stirnplatte 6 mit einem in Richtung der Achse A-A weisenden Vorsprung 7, der wiederum eine kreisringförmige Stirnseite 7a aufweist. Durch den Vorsprung 7 wird die Außenseite der Stirnplatte 6 in eine innere Kreisfläche 6a und eine hierzu konzentrische, äußere Kreisringfläche 6b unterteilt, die beide in einer gemeinsamen Ebene liegen. Auf der Innenseite der Stirnplatte 6 befinden sich zwei Konzentrische Kühlwasserkanäle 8 und 9, die einen Zylinderspalt 10 zwischen sich einschliessen, der bis in den Vorsprung 7 hineinragt.

Auf der Außenseite der Stirnplatte 6 ist durch Bonden ein Target 11 befestigt, das aus einem inneren kreisscheibenförmigen Teil 11a und aus einem äußeren kreisringförmigen Teil 11b besteht, wobei die Grundflächen dieser Teile mit der jeweils zugehörigen Kreisfläche 6a bzw. der Kreisringfläche 6b kongruent sind. Auf dem Vorsprung 7 ist ein weiteres kreisringförmiges Teil 11c des Targets angeordnet, welches den Vorsprung 7 radial einwärts und radial auswärts überragt, so daß eine Überlappung mit den Teilen 11a und 11b besteht. Die Dicke der Targetteile 11a und 11b ist dabei geringer als die Höhe des Vorsprungs 7, so daß in Richtung der Achse A-A zwischen dem Teil 11c und dem Teil 11a einerseits und dem Teil 11c und dem Teil 11b andererseits jeweils ein radialer Luftspalt gebildet wird, der das aus ferromagnetischem Werkstoff bestehende Target 11 magnetisch unterteilt. Die Luftspalte sind dabei enger, als der sich unter den Betriebsbedingungen einstellende Dunkelraumabstand, so daß in den Luftspalten keinerlei Glimmentladung auftritt.

In der hinteren Öffnung des Grundkörpers 2 befindet sich ein Magnetsystem 13 mit mehreren Magneteinheiten 14, 15 und 16, die in Bezug auf die Achse A-A ineinanderliegen und sämtlich aus permanentmagnetischem Material bestehen und in axialer Richtung magnetisiert sind. Die zentrale Magneteinheit 14 hat dabei die Form eines gedrungenen Zylinders. Die Magneteinheiten 15 und 16 sind dabei aus mehreren quaderförmigen Permanentmagneten zusammengesetzt, deren Polflächen gleicher Polung jeweils im wesentlichen in einer Kreisringfläche liegen. Hierbei sei vernachlässigt, daß eine solche Aneinanderreihung von Permanentmagneten in Wirklichkeit zu einem vieleckigen Polygon führt. Die dem Target 11 abgekehrten Pole der Magneteinheiten 14, 15 und 16 sind über ein Magnetjoch 17 aus weichmagnetischem Material in der in Figur 1 gezeigten Weise miteinander verbunden. Das Magnetjoch 17 besteht dabei aus einem äußeren Jochteil 17a, dessem Grundfläche eine Kreisringfläche ist, und aus einem inneren Jochteil 17b, dessen Grundfläche eine Kreisfläche ist. Das äußere Jochteil 17a besitzt zur Achse A-A konzentrische Rippen 17c und 17d, deren dem Target 11 zugekehrte kreisringförmige Stirnflächen die Auflagenflächen für die Magneteinheiten 15 bzw. 16 sind.

Die Magneteinheiten sind dabei abwechselnd unterschiedlich gepolt, und zwar bilden die dem Target 11 zugekehrten Polflächen bei der Magneteinheit 14 einen Nordpol, bei der Magneteinheit 15 einen Südpol und bei der Magneteinheit 16 wieder einen Nordpol. Dies führt im Hinblick auf die zwischen den Targetteilen 11a, 11b und 11c vorhandenen Luftspalte zur Ausbildung zweier magnetischer Tunnels 19 und 20, deren Feldlinien in der rechten Hälfte von Figur 1 gestrichelt dargestellt sind. In Wirklichkeit folgen die Tunnels 19 und 20 dem Verlauf der Luftspalte, sind also um die Achse A-A umlaufend geschlossen.

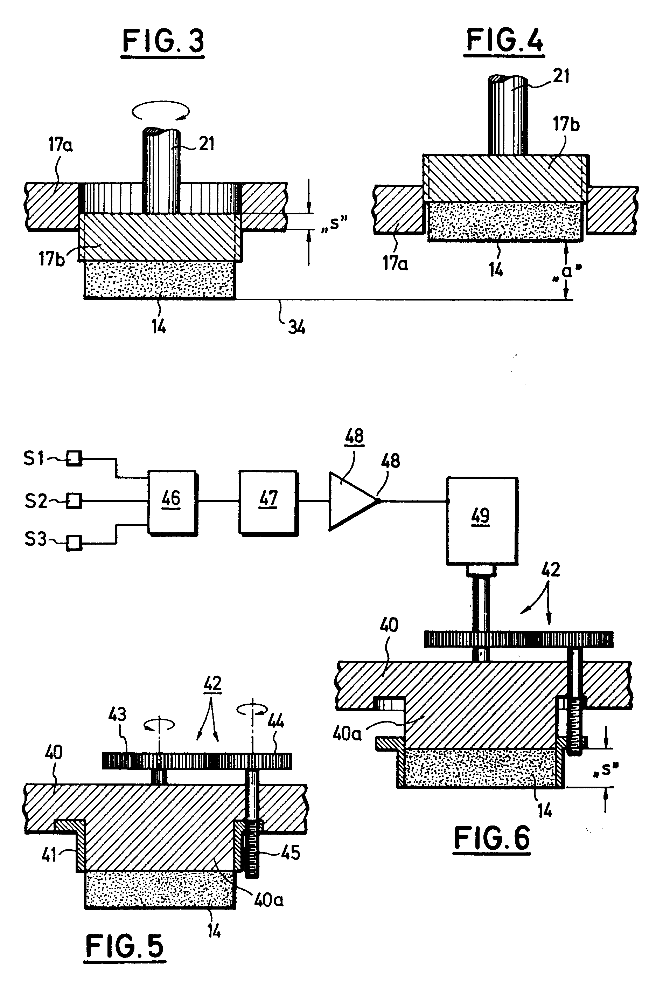

Das innere Jochteil 17b ist in einer Ausnehmung 17e des äußeren Jochteils 17a in Normalenrichtung zur Hauptebene des Targets 11, d.h. in Richtung der Achse A-A unter Veränderung der Überlappung "s" verstellbar (Figur 3). Zur Verstellung dient eine Verstelleinrichtung 21, durch die der innere Jochteil 17b in Drehung versetzt werden kann. Da zwischen den beiden Jochteilen 17a und 17 eine Gewindeverbindung besteht, läßt sich durch Drehen der Verstelleinrichtung 21 das innere Jochteil 17b aus dem äußeren Jochteil 17a heraus oder in dieses hineinschrauben. Eine zur Figur 3 entgegengesetzte Lage der beiden Jochteile zueinander ist in Figur 4 dargestellt. Durch die Verstelleinrichtung 21 wird erreicht, daß der magnetische Fluß zwischen dem Magnetjoch 17 und der Magneteinheit 14 gegenüber dem magnetischen Fluß zwischen dem gleichen Magnetjoch 17 und den übrigen Magneteinheiten 15 und 16 verändert wird. Der magnetische Fluß zwischen den Magneteinheiten 15 und 16 bleibt hiervon jedenfalls im wesentlichen unbeeinflußt. Diese Maßnahme führt dazu, daß die magnetische Feldstärke des den Tunnel 20 bildenden Magnetfeldes relativ zu der magnetischen Feldstärke des den Tunnel 19 bildenden Magnetfeldes verändert wird. Auf diese Weise lassen sich die Zerstäubungsraten im Bereich der magnetischen Tunnel 19 und 20 unabhängig voneinander verändern, womit sich die örtlichen Schichtdicken auf dem Substrat 22 gezielt beeinflussen lassen, das dem Target 11 gegenüber in einem üblichen Abstand angeordnet ist und mit dem Material des Targets 11 (oder einem Reaktionsprodukt hieraus) beschichtet werden soll.

In Figur 2 ist eine Zerstäubungskatode 30 dargestellt, deren Target 31 einteilig ausgebildet ist und aus nicht-magnetischem Material besteht. Infolgedessen besitzt der Grundkörper 32 eine ebene Stirnplatte 33, auf die das Target 31 aufgebondet ist. Da bei einem derartigen Targetmaterial die Ausbildung von Luftspalten überflüssig ist, fehlt der Stirnplatte 33 auch ein entsprechender Vorsprung. Das Magnetsystem 13 ist im wesentlichen identisch aufgebaut, lediglich die Rippe 17c des äußeren Jochteils 17a ist kürzer ausgebildet, da die Polflächen der Magneteinheiten 15 und 16 in einer gemeinsamen Ebene 34 liegen, in der bei der dargestellten Einstellung des Jochteils 17b auch die Polfläche der Magneteinheit 14 liegt. Das Verstellprinzip ist hierbei das gleiche wie bei Figur 1, so daß die Lage der Polfläche der Magneteinheit 14 relativ zur Ebene 34 auch verändert werden kann, wie dies in Figur 4 durch den Abstand "a" angedeutet ist. Es ist mithin erkennbar, daß mit der Veränderung des magnetischen Übergangswiderstandes zwischen den Jochteilen 17a und 17b auch der Abstand des Jochteils 14 vom Target 11 veränderbar ist. Durch Vergrößerung des Abstandes "a" kann beispielhaft die Feldstärke des inneren magnetischen Tunnels 20 gegenüber derjenigen des äußeren magnetischen Tunnels 19 verringert werden. Dies wirkt in vorteilhafter Weise dem Konzentrationseffekt der magnetischen Feldlinien entgegen, der dadurch auftritt, daß bei ineinanderliegenden rotationssymmetrischen Magnetsystemen notwendigerweise am jeweils kleinsten Radius die größte Feldstärke auftritt. Sofern dieser Effekt unbeeinflußt bleibt, würde dies zu dem weiter oben beschriebenen Effekt führen, daß in der Mitte des Substrats 22, also im Bereich der Achse A-A, eine sehr viel größere Schichtdicke auftritt als beispielsweise am Rande des Substrats 22 (vorausgesetzt, daß dies eine Kreisscheibe ist und keine Querbewegung zur Achse A-A ausführt).

Auch in Figur 2 sind in der rechten Hälfte gestrichelt die Feldlinien zweier magnetischer Tunnels 19 und 20 eingezeichnet, die durch das Magnetsystem 13 erzeugt werden. Die Beeinflussung der relativen Feldstärken der betreffenden magnetischen Felder durch räumliche Verschiebung des Jochteils 17b gegenüber dem Jochteil 17a ist im Prinzip die gleiche wie bei dem Gegenstand von Figur 1.

Die Figuren 5 und 6 zeigen eine andere konstruktive Möglichkeit zur relativen Veränderung der magnetischen Feldstärke des äußeren Tunnels 19 relativ zum inneren Tunnel 20 bzw. zur Veränderung des magnetischen Flusses zwischen dem Magnetjoch und der Magneteinheit 14 einerseits und dem magnetischen Fluß zwischen dem Magnetjoch 17 und den übrigen Magneteinheiten 15 und 16 andererseits. Dies geschieht dadurch, daß das Magnetjoch 40 auf einem Teil seiner Oberfläche, nämlich in der Mitte, einen Vorsprung 40a aufweist, auf dem die zentrale Magneteinheit 14 kongruent mit dem Vorsprung 40a angeordnet ist. Auf dem Vorsprung 40a ist eine aus weichmagnetischem Material bestehende, am Vorsprung eng anliegende und auf diesem verschiebbare Hülse 41 angeordnet, die in axialer Richtung über die Magneteinheit 14 derart verstellbar ist, daß das Maß "s" der Überlappung von Hülse und Magneteinheit veränderbar ist (Figur 6). Die Verstellung geschieht durch eine Verstelleinrichtung 42, die aus einem Zahnradpaar 43 und 44 besteht. Das Zahnrad 44 treibt eine Gewindespindel 45 an, die in einen Flansch 41a an der Hülse 41 eingreift. Dadurch läßt sich die Hülse 41 aus der oberen Endstellung gemäß Figur 5 in eine untere Endstellung gemäß Figur 6 verschieben. Die Hülse 41 stellt einen "Shunt" dar, der einen Teil des magnetischen Flusses von der freien Stirnseite der Magneteinheit 14 auf dem Weg des geringsten Widerstandes in das Magnetjoch 40 zurückführt und dadurch das aus der Polfläche der Magneteinheit 14 austretende Feld schwächt. Die Verstellsysteme nach den Figuren 1 bis 4 einerseits und 5 bis 6 andererseits lassen sich zur Erfüllung der Aufgabe gegeneinander austauschen.

Während anhand der Figuren 1 und 2 primär rotationssymmetrische Zerstäubungskatoden erörtert wurden, gilt das Prinzip der Anordnung naturgemäß auch für langgestreckte Katoden, d.h. für solche, die man sich beliebig in einer Richtung senkrecht zur Zeichenebene verlängert denken kann. Man kann sich eine solche langgestreckte Katode dadurch gebildet vorstellen, daß man eine rotationssymmetrische Katode nach den Figuren 1 und 2 entlang der Achse A-A diametral durchtrennt und zwischen den beiden Hälften einen Abstand bildet und diesen Abstand mit einem geradlinigen Katodenteil ausfüllt, dessen Querschnitt exakt den Querschnitten in Figur 1 oder 2 entspricht. Bei derartigen Zerstäubungskatoden wird man zweckmäßig über die Länge verteilt mehrere Verstelleinrichtungen anordnen, um die jeweils inneren Jochteile 17b exakt gegenüber den äußeren Jochteilen 17a führen zu können. An dem grundsätzlichen Verstellprinzip ändert sich hierdurch nichts.

Zur besseren Übersicht sind in den Figuren 1 und 2 die Magnetsysteme etwas nach oben angehoben dargestellt. In Wirklichkeit befinden sich die Magneteinheiten möglichst dicht hinter der Stirnplatte 6, indem sie in die gezeichneten Hohlräume eintauchen.

Figur 6 zeigt noch den Einsatz des Systems der relativen Feldstärkebeeinflussung in Verbindung mit einer automatischen Regelung: Drei Sensoren S1, S2 und S3 für die Erfassung der Schichtdickenverteilung auf dem jeweiligen Substrat 22 sind einem Differenzverstärker 46 aufgeschaltet, dessen Ausgang einem Regler 47 zugeführt wird. Dessen Ausgang ist wiederum einem Leistungsverstärker 48 aufgeschaltet. Der Ausgang 48a des Leistungsverstärkers ist mit einem Stellmotor 49 für den Antrieb der Verstelleinrichtung 42 verbunden, so daß sich durch Verschiebung der Hülse 41 eine optimale Schichtdickenverteilung einregeln läßt. Für die Verstelleinrichtung 21 in den Figuren 3 und 4 gelten analoge Überlegungen.

## Patentansprüche

1. Zerstäubungskatode nach dem Magnetronprinzip mit einem aus mindestens einem Teil bestehenden Target (11) aus dem zu zerstäubenden Material mit einem hinter dem Target (11) angeordneten, im wesentlichen in einer Ebene ausgebreiteten Magnetsystem (13) mit mehreren, ineinander liegenden und in sich geschlossenen Magneteinheiten (14,15,16) abwechselnd unterschiedlicher Polung, durch die mindestens zwei gleichfalls in sich geschlossene ineinanderliegende magnetische Tunnels (19,20) aus bogenförmig gekrümmten Feldlinien gebildet werden, wobei die dem Target (11) abgekehrten Pole der Magneteinheiten (14,15,16) über ein Magnetjoch (17) aus weichmagnetischem Material miteinander verbunden sind, dadurch gekennzeichnet, daß mindestens drei ineinanderliegende permanentmagnetische Magneteinheiten (14, 15, 16) vorhanden sind und daß eine mechanische Verstelleinrichtung (21, 42) vorhanden ist, durch die der magnetische Fluß zwischen dem Magnetjoch (17) und mindestens einer Magneteinheit (14) gegenüber dem magnetischen Fluß zwischen dem Magnetjoch (17) und den übrigen Magneteinheiten (15, 16) veränderbar ist.

2. Zerstäubungskatode nach Anspruch 1, dadurch gekennzeichnet, daß das Magnetjoch (17) aus je einem äußeren (17a) und einem inneren Jochteil (17b) be steht, die unter Veränderung des zwischen ihnen bestehenden magnetischen Übergangswiderstandes relativ zueinander verstellbar sind.

3. Zerstäubungskatode nach Anspruch 2, dadurch gekennzeichnet, daß mit der Veränderung des magnetischen Übergangswiderstandes auch der Abstand mindestens eines der Jochteile (14) vom Target (11) veränderbar ist.

4. Zerstäubungskatode nach Anspruch 3, dadurch gekennzeichnet, daß das innere Jochteil (17b) in einer Ausnehmung des äußeren Jochteils (17) in Normalenrichtung zur Hauptebene des Targets unter Veränderung der Überlappung "s" verstellbar ist.

5. Zerstäubungskatode nach Anspruch 1 dadurch gekennzeichnet, daß das Magnetjoch (40) auf einem Teil seiner Oberfläche einen Vorsprung (40a) aufweist, auf dem eine der Magneteinheiten (14) im wesentlichen kongruent mit dem Vorsprung (40a) angeordnet ist, und daß auf dem Vorsprung (40a) eine aus weichmagnetischem Material bestehende, am Vorsprung (40a) eng anliegende und auf diesem verschiebbare Hülse (41) angeordnet ist, die in axialer Richtung über die Magneteinheit (14) derart verstellbar ist, daß das Maß "s" der Überlappung von Hülse (41) und Magneteinheit (14) veränderbar ist.

## Claims

1. Sputtering cathode operating on the magnetron principle, with a target (11) comprising at least one part, made of the material to be sputtered, with a magnet system (13) arranged behind the target (11) and essentially extended in one plane, with several self-contained magnet units (14, 15, 16) of alternate polarity located inside each other, by which at least two likewise self-contained magnetic tunnels (19, 20) located inside each other are formed from arch-shaped, curved lines of force, whereby the poles of the magnet units (14, 15, 16) facing away from the target are interconnected by a magnet yoke (17) made of soft magnetic material, characterised in that at least three permanent magnet units (14, 15, 16) that are located inside each other are provided and that a mechanical adjusting device (21, 42) is provided, by which the magnetic flux between the magnet yoke (17) and at least one magnet unit (14) can be varied in relation to the magnetic flux between the magnet yoke (17) and the remaining magnet units (15, 16).

2. Sputtering cathode according to claim 1, characterised in that the magnet yoke (17) comprises outer (17a) and inner (17b) yoke sections, respectively, which can be adjusted in relation to each other by varying the magnetic transition resistance that exists between.

3. Sputtering cathode according to claim 2, characterised in that along with the variation in the magnetic transition resistance, the distance of at least one of the yoke sections (14) from the target (11) can also be varied.

4. Sputtering cathode according to claim 3, characterised in that the inner yoke section (17b) can be adjusted in a recess in the outer yoke section (17) in the direction normal to the principal plane of the target by varying the "s" overlap.

5. Sputtering cathode according to claim 1, characterised in that the magnet yoke (40) has a projection (40a) on one part of its surface, on which one of the magnet units (14) is arranged essentially congruent with the projection (40a), and that a sliding sleeve (41) consisting of soft magnetic material is arranged on the projection (40a) and is in close contact with the projection (40a), said sliding sleeve (41) being able to be adjusted in an axial direction over the magnet unit (14) in such a way that the dimension "s" of the overlap between sleeve (41) and magnet unit (14) can be varied.

## Revendications

1. Cathode de pulvérisation selon le principe du magnétron, comportant une cible (11) composée d'au moins une partie, réalisée dans le matériau devant être pulvérisé, comportant également un système d'aimant (13) disposé derrière la cible (11), s'étendant sensiblement dans un plan et comprenant plusieurs unités d'aimant (14, 15, 16) disposées les unes dans les autres, fermées en soi et de polarités alternativement différentes, par lesquelles sont formées au moins deux tunnels magnétiques (19, 20) constitués de lignes de champ courbées en forme de voûte, les pôles des unités d'aimant (14, 15, 16), éloignés de la cible (11), étant reliés entre-eux par l'intermédiaire d'une culasse d'aimant (17) en un matériau magnétique doux, caractérisée en ce que sont prévues au moins trois unités d'aimant à aimantation permanente (14, 15, 16) disposées les unes dans les autres, et en ce qu'est prévu un dispositif de réglage mécanique (21, 42), par l'intermédiaire duquel il est possible de modifier le flux magnétique entre la culasse d'aimant (17) et au moins une unité d'aimant (14), par rapport au flux magnétique entre la culasse d'aimant (17) et les autres unités d'aimant (15, 16).

2. Cathode de pulvérisation selon la revendication 1, caractérisée en ce que la culasse d'aimant (17) est constituée respectivement d'une partie de culasse extérieure (17a) et d'une partie de culasse intérieure (17b), qui peuvent être déplacées relativement l'une par rapport à l'autre en produisant une variation de la résistance de contact magnétique.

3. Cathode de pulvérisation selon la revendication 2, caractérisée en ce qu'avec la variation de la résistance de contact magnétique, la distance d'au moins une des parties de culasse (14) à la cible (11) peut également être modifiée.

4. Cathode de pulvérisation selon la revendication 3, caractérisée en ce que la partie de culasse intérieure (17b) peut être déplacée dans un évidement de la partie extérieure de culasse (17), dans la direction normale au plan principal de la cible, en modifiant le chevauchement "s".

5. Cathode de pulvérisation selon la revendication 1, caractérisée en ce que la culasse d'aimant (40) comporte sur une partie de sa surface, une protubérance (40a) sur laquelle est agencée l'une des unités d'aimant (14) de manière à coïncider sensiblement à la protubérance (40a), et en ce que sur la protubérance (40a) est disposée une douille (41) en un matériau magnétique doux, appliquée étroitement contre la protubérance (40a) et pouvant coulisser sur celle-ci, la douille pouvant être déplacée en direction axiale sur l'unité d'aimant (14), de manière à ce que la valeur "s" du chevauchement entre la douille (41) et de l'unité d'aimant (14) puisse être modifiée.
